# EUROPÄISCHE PATENTSCHRIFT

(11) **EP 4 428 814 B1**
(45) Veröffentlichungstag und Bekanntmachung des Hinweises auf die Patenterteilung: **10.09.2025**
(21) Anmeldenummer: 24162347.9
(22) Anmeldetag: 08.03.2024
(51) Int. Cl.: G06T 7/00, G01B 11/06, G01B 11/14

(54) **LOTSPALTMESSUNG AN BAUTEILEN AUF AUTOMATISCH OPTISCH ZU PRÜFENDEN LEITERPLATTEN**
MEASURING SOLDER GAP ON COMPONENTS ON PRINTED CIRCUIT BOARDS THAT ARE AUTOMATICALLY OPTICALLY TESTED
MESURE DE LA FENTE DE SOUDURE SUR DES COMPOSANTS SUR DES CARTES DE CIRCUITS IMPRIMÉS À TEST OPTIQUE AUTOMATIQUE

(30) Priorität: 08.03.2023 DE 102023105796
(43) Veröffentlichungstag der Anmeldung: 11.09.2024
(73) Patentinhaber: GÖPEL electronic GmbH, 07745 Jena (DE); Robert Bosch GmbH, 70442 Stuttgart (DE)
(72) Erfinder: KOKOTT, Jens, 07749 Jena (DE); HAUSWALD, Frank, 99423 Weimar (DE); MAGER, Christiane, 71101 Schönaich (DE); RATCHEV, Roumen, 70499 Stuttgart (DE); MANIAR, Youssef, 70190 Stuttgart (DE); GLEICHAUF, Jonas, 70193 Stuttgart (DE)
(74) Vertreter: Gleim Petri Patent- und Rechtsanwaltspartnerschaft mbB

(56) Entgegenhaltungen:
- US-A1- 2001 024 273
- US-B2- 8 574 932

## Beschreibung

Die Erfindung betrifft eine Vorrichtung und ein Verfahren zur Messung eines Spaltes an einer Seitenfläche eines Bauteils auf einer mittels automatischer optischer Inspektion zu prüfenden Leiterplatte, insbesondere zur Messung der Spaltbreite eines Lotspaltes, vorzugsweise an Bauteilen der Leistungselektronik, und bevorzugt zur Bewertung der Lebensdauer und Zuverlässigkeit von elektronischen Bauelementen und Baugruppen.

Bei der Fertigung von elektronischen Baugruppen, Schaltungen und Leiterplatten werden immer häufiger Qualitätskontrollen in einzelnen Fertigungsstufen durch Systeme zur automatischen optischen Inspektion (AOI-Systeme) durchgeführt. Dabei werden zu definierten Fertigungszeitpunkten der Produktion elektronischer Baugruppen, z.B. als bestückte Leiterplatten, offensichtliche Produktionsfehler festgestellt. Die Fehlererkennung umfasst fehlende Bauelemente, Falschbestückung, fehlerhafte Positionierung, Lötfehler, angefangen von ungelöteten Bauteilen, kurzgeschlossenen Bauteilen oder Leiterbahnen bis zu mangelhaftem Lötstellenaussehen und/oder -volumen sowie Verunreinigungen oder Beschädigungen der Leiterplatte.

Die Leiterplatten können dabei durch Bildaufnahmen mit Scannern oder mit Kameras inspiziert werden. Während bei Scannern die Leiterplatte in der Regel nur einmal überfahren wird bzw. unter dem Scanner hindurchbewegt, sind Kameras zumeist von oben auf die Platte gerichtet und müssen aufgrund des begrenzten Sichtbereiches mit einer X-Y-Verfahreinrichtung bewegt werden. Es kommen aber auch Mehrkamerasysteme und Systeme mit schräg angebrachten Kameras zum Einsatz. Die Auswertung der Bilder zur Fehlererkennung erfolgt dann durch Vergleich mit dem CAD-Datensatz der inspizierten Leiterplatte.

Eine Vorrichtung zur Inspektion von flachen Objekten, insbesondere Wafern, ist aus der DE 10 2012 111 835 A1 bekannt, wobei die Inspektionsvorrichtung eine Kameraanordnung mit mindestens zwei Kameras enthält, die jeweils zur Aufnahme eines Bildes eines Teilbereichs des Objekts geeignet sind. Dabei sind die von unterschiedlichen Kameras abgebildeten Objektfelder zumindest größtenteils unterschiedlich und die Kameras erfassen gemeinsam mit geringen Überlappungen nur einen Teil des gesamten Inspektionsbereichs des Objekts gleichzeitig. Durch eine mit einer Antriebsanordnung erzeugte Relativbewegung zwischen Kameraanordnung und Objekt ist jeder Objektpunkt des gesamten Inspektionsbereichs zumindest einmal in eine der Kameras abbildbar. Dabei sind die Kameras mit parallelen Kameraachsen orthogonal über der Objektoberfläche ausgerichtet.

Darüber hinaus sind auch Anordnungen zur automatischen optischen Inspektion mit unterschiedlichen Neigungswinkeln zur optisch abzutastenden Oberflächen beispielsweise aus der US 7 075 565 B1 bekannt. Diese Kameraanordnung wird mit Mäandermuster über das Objekt bewegt, um das Objekt streifenförmig abzutasten, wobei die Kameras eine domähnliche Konfiguration aufweisen, bei der eine Kamera senkrecht und beispielsweise vier Kameras verteilt herum mit 30°-Abweichung von der Normalposition angeordnet sind. Ein Computer steuert dann die Auslesung der Kameras nach deren Beitrag zum gesamten Blickfeld (FOV) der Kameraanordnung, um eine schnelleren Abtastfortschritt zu erreichen. Eine Beleuchtungseinheit ist am Rande des Kameradoms angeordnet, um die geeignete Beleuchtung des FOV zu gewährleisten. Die Anordnung nimmt dabei getriggert Bilder verschiedener Kameras auf, um die 3D-Kontrolle zu perfektionieren, kann aber keine speziellen Aufgaben der Kontrolle der Zuverlässigkeit der Bauelemente und Lötverbindungen übernehmen.

Der Erfindung liegt die Aufgabe zugrunde, eine neuartige Möglichkeit zum Messen von Spaltmaßen elektronischer Bauteile, insbesondere eines Lotspalts des Bauteils gegenüber der Leiterplatte, durch ein AOI-System zu finden. Ferner soll ein Verfahren zum Messen der Spaltbreite für unterschiedliche Bauteile bereitgestellt werden, das eine optimale Anpassung des Kontrastverhältnisses des Spaltes erlaubt und aus der Spaltbreite (Standoff) einen Indikator für die Zuverlässigkeit der Bauteilfunktion gegen Ausfallerscheinungen abzuleiten gestattet.

Erfindungsgemäß wird die Aufgabe bei einer Vorrichtung zur Messung eines Spaltes an einem Bauelement auf einer mittels automatischer optischer Inspektion zu prüfenden Leiterplatte gelöst durch eine Kameraanordnung, die mindestens eine unter einem Neigungswinkel α zu der zu prüfenden Leiterplatte angeordnete geneigte Kamera enthält, die dazu ausgebildet ist, eine Seitenfläche eines zu prüfenden Bauteils abzubilden, um die Seitenfläche auf einen vorhandenen Spalt untersuchen zu können, eine Beleuchtungseinrichtung mit einem gerichteten Beleuchtungsstrahl, die in einem Blickfeld der geneigten Kamera eine im Wesentlichen orthogonale Ausrichtung zur Leiterplatte aufweist, eine Transporteinrichtung, die für eine relative Bewegung zwischen der Leiterpatte einerseits und der Kameraanordnung und der Beleuchtungseinrichtung andererseits derart ausgebildet ist, dass ein zu prüfendes Bauelement in dem Blickfeld der geneigten Kamera so angeordnet ist, dass eine Neigungswinkelebene der geneigten Kamera einen rechten Winkel zu der Seitenfläche des zu prüfenden Bauteils aufweist, und eine Steuer- und Auswerteeinrichtung, die derart eingerichtet ist, dass die Beleuchtungseinrichtung mindestens in der Helligkeit in unterschiedlichen Stufen steuerbar ist, und synchron dazu durch die mindestens eine geneigte Kamera eine Serie von Bildern der Seitenfläche des Bauteils aufnehmbar ist, wobei eine Bildauswerteeinheit dazu ausgebildet ist, in einem von der geneigten Kamera aufgenommenen Bild Kantenverläufe zu detektieren, die dem vorhandenen Spalt zuzuordnen sind, von dem eine Spaltbreite b ermittelbar ist.

Vorteilhaft ist als Neigungswinkel α der geneigten Kamera ein Winkel zwischen 10° und 80° eingestellt. Bevorzugt wird als Neigungswinkel α ein Winkel zwischen 40° und 70°, insbesondere zwischen 45° und 60° gewählt.

Die geneigte Kamera der Kameraanordnung weist vorteilhaft eine Auflösung von mindestens 50 µm/Pixel, vorzugsweise 15-25 µm/Pixel auf.

Die Transporteinrichtung ist zweckmäßig so ausgebildet, um die Neigungswinkelebene im Wesentlichen orthogonal zu einer Seitenfläche des zu prüfenden Bauteils einzurichten.

Die Beleuchtungseinrichtung zum Aussenden einer gerichteten Beleuchtung ist vorteilhaft so ausgebildet, um bevorzugt eine gerichtete Koaxialbeleuchtung oder alternativ eine um eine 90°-Kamera angeordnete Ringbeleuchtung synchronisiert zur Bildaufnahme der geneigten Kamera zu aktivieren, wenn die Seitenfläche des zu messenden Bauteils im Blickfeld der geneigten Kamera vorhanden ist.

In einer vorteilhaften Ausführung umfasst die Steuer- und Auswerteeinrichtung eine Beleuchtungs- und Abtaststeuerung, die derart ausgebildet ist, um die Bildaufnahmen mindestens der geneigten Kamera, der Beleuchtungseinrichtung und der Transporteinrichtung zu synchronisieren.

Zweckmäßig enthält die Steuer- und Auswerteeinrichtung eine Bildauswerteeinheit, die derart ausgestattet ist, um aufgenommene Bilder von einer Seitenfläche des Bauteils auf Kantenverläufe zu analysieren. Dafür ist die Bildauswerteeinheit vorzugsweise so ausgestattet, um im aufgenommenen Bild eine rechteckige ROI orthogonal zu mindestens einem Kantenverlauf festzulegen und innerhalb der ROI gegenüberliegende Kantenübergänge des Spaltes zu detektieren und daraus die Spaltbreite b zu berechnen. Dabei kann die rechteckige ROI vorteilhaft im aufgenommenen Bild entlang des Kantenverlaufs verschoben und daraus ein Verlauf der Spaltbreite b über eine Spaltlänge a ermittelt werden oder die rechteckige ROI ist im aufgenommenen Bild entlang des Kantenverlaufs zu verschieben, um daraus eine Spaltbreite b, gemittelt über eine Spaltlänge a, zu berechnen.

Besonders vorteilhaft ist die Bildauswerteeinheit dahingehend erweiterbar, um aus der ermittelten Spaltbreite b einen Indikationsfaktor für die Bestimmung der Zuverlässigkeit der Bauteilfunktion gegen Ausfallerscheinungen abzuleiten.

Die Aufgabe wird weiterhin bei einem Verfahren zur Messung eines Spaltes an einer Seitenfläche eines Bauteils auf einer mittels automatischer optischer Inspektion zu prüfenden Leiterplatte gelöst durch die Schritte:
- Bereitstellen einer Kameraanordnung, die mindestens eine geneigte Kamera enthält, die unter einem Neigungswinkel α zu der Leiterplatte ausgerichtet wird, eine Seitenfläche eines zu messenden Bauteils so abzubilden, um die Seitenfläche auf einen vorhandenen Spalt untersuchen zu können, und einer Beleuchtungseinrichtung mit einer gerichteten Beleuchtung, die im Blickfeld der geneigten Kamera im Wesentlichen orthogonal zur Leiterplatte ausgerichtet wird,
- Relativbewegung zwischen der Leiterplatte einerseits sowie der Kameraanordnung und Beleuchtungseinrichtung andererseits, um ein zu prüfendes Bauteil in dem Blickfeld der geneigten Kamera so zu positionieren, dass eine Neigungswinkelebene der geneigten Kamera im Wesentlichen orthogonal zu der Seitenfläche des zu prüfenden Bauteils steht,
- Ansteuern der Beleuchtungseinrichtung in unterschiedlichen Beleuchtungsmodi, bei denen die Beleuchtung mindestens in ihrer Helligkeit variiert wird, um eine Serie von aufgenommenen Bildern des Bauteils mit dem Spalt an der Seitenfläche des Bauteils mit unterschiedlichem Kontrast aufzunehmen,
- Bewerten von Kontrastverhältnissen in den mit variierter Helligkeit aufgenommenen Bildern mittels einer Bildauswerteeinheit und Auswählen des aufgenommenen Bildes mit bestem Kontrast, um Kantenverläufe zu erkennen,
- Detektieren von Kantenverläufen mittels der Bildauswerteeinheit und Ermitteln von gegenüberliegenden Kantenübergängen, die dem vorhandenen Spalt zuzuordnen sind, und Bestimmen der Spaltbreite b als Abstand gegenüberliegender Kantenübergänge.

Vorteilhaft wird eine Variation der Beleuchtung für die Bildaufnahmen der geneigten Kamera in der Helligkeit durch stufenweise Änderung der Intensität vorgenommen. Dabei wird die Intensität der Beleuchtung für Bildaufnahmen der geneigten Kamera typischerweise um das Zwei- bis Zehnfache erhöht gegenüber einem Kalibriernormal für die herkömmliche AOI-Abtastung der Leiterplatte mittels 90°-Kameras. Besonders bevorzugt wird die Intensität der Beleuchtung für Bildaufnahmen der geneigten Kamera auf das Vier- bis Achtfache des Kalibriernormals erhöht.

In einer bevorzugten Verfahrensgestaltung wird die Spaltbreite b des Spaltes mittels Festlegen einer rechteckigen ROI orthogonal zu detektierten Kantenverläufen und Auswerten von Kantenübergängen innerhalb der ROI auf Basis des Abstandes der Kantenübergänge bestimmt. Dabei kann die Spaltbreite b des Spaltes zweckmäßig durch Verschieben der ROI entlang der Kantenverläufe entweder als Verlauf der Spaltbreite b oder als Mittelwert über die Spaltlänge a berechnet werden.

Durch die Vorrichtung und das Verfahren ist es möglich, Spaltmaße elektronischer Bauteile, insbesondere des Lotspalts eines Bauteils gegenüber der Leiterplatte, durch ein AOI-System zu messen. Mit dem die Verfahren zum Messen der Spaltbreite wird eine optimale Anpassung des Kontrastverhältnisses des Spaltes für unterschiedliche Bauteile bereitgestellt, und aus der damit zuverlässig ermittelten Spaltbreite (Standoff) kann ein Indikator für die Zuverlässigkeit der Bauteilfunktion gegen Ausfallerscheinungen abgeleitet werden.

Die Erfindung soll nachfolgend durch Ausführungsbeispiele anhand von Zeichnungen näher beschrieben werden. Hierzu zeigen:
- Fig. 1: eine Ausführung der erfindungsgemäßen Vorrichtung zur Messung eines Spaltes an einem Bauteil gegenüber einer Leiterplatte,
- Fig. 2: einen Ausschnitt aus Fig. 1 mit einem zu prüfenden Bauteil mit Lotspalt, bei dem zur Kontrastverbesserung der Bildaufnahme ein Kontrastpad auf der Leiterplatte aufgebracht ist,
- Fig. 3: eine weitere Ausführung der erfindungsgemäßen Vorrichtung mit einem anderen Bauteil und mit einer Ringbeleuchtung um eine der üblichen 90°-Kameras zur AOI-Abrasterung der Leiterplatte,
- Fig. 4: eine Prinzipdarstellung zur Erläuterung der Beleuchtungsanpassung für die geneigte Kamera im Vergleich zum Kalibriernormalwert der Beleuchtung bei herkömmlicher AOI-Abtastung der Leiterplatte mit 90°-Kameras,
- Fig. 5: eine schematische Darstellung der Steuer- und Auswerteeinrichtung zur Ermittlung der Spaltbreite (Standoff) eines Bauteils.

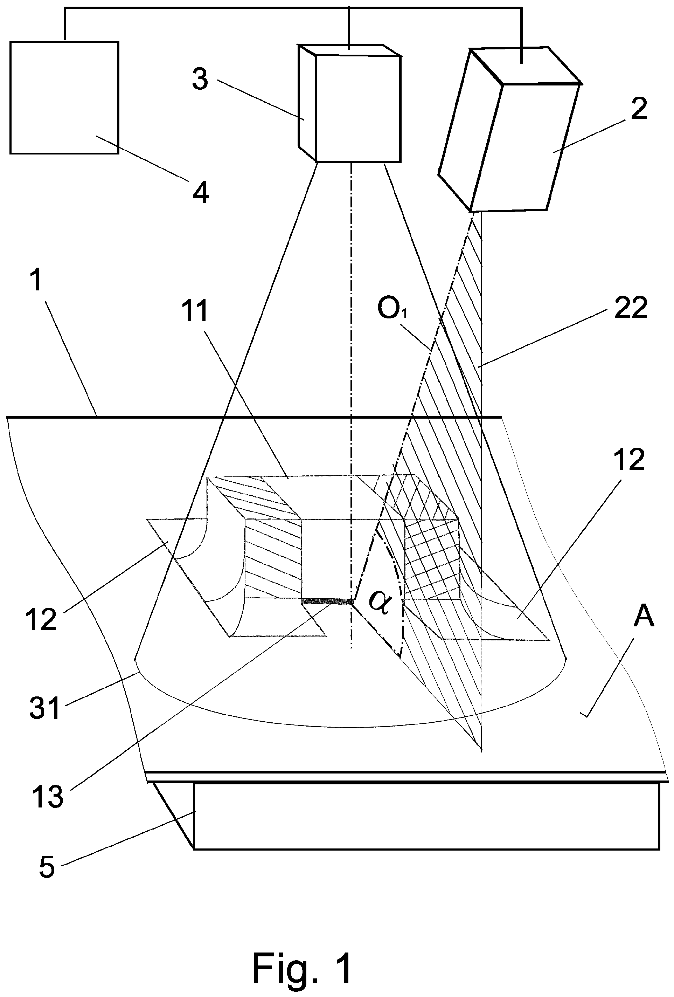

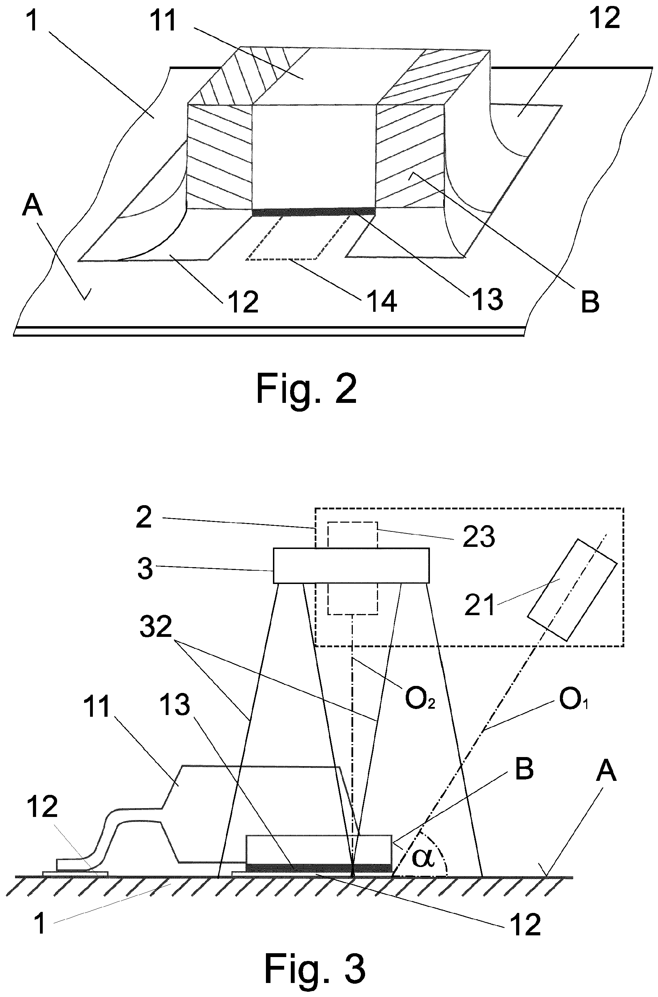

Ein Grundaufbau der erfindungsgemäßen Vorrichtung - wie in Fig. 1 schematisch dargestellt - umfasst eine zu prüfende Leiterplatte 1, die mindestens ein Bauteil 11 mit Lötstellen auf vorgegebenen Lötpads 12 und einem zu messenden Spalt, hier vorzugsweise ein Lotspalt 13, aufweist, eine Kameraanordnung 2 mit mindestens einer geneigten Kamera 21 (nur in Fig. 3 bezeichnet), eine Beleuchtungseinrichtung 3 zur Beleuchtung mindestens des Blickfeldes der Kameraanordnung 2, eine Steuer- und Auswerteeinrichtung 4 zur Steuerung von Kameraanordnung 2 und Beleuchtungseinrichtung 3 für die Bildaufnahme und Auswertung der aus der mindestens einen schrägen Kamera 21 ausgelesenen Bilder 43 sowie eine Transporteinrichtung 5 zur Erzeugung einer relativen Bewegung zwischen der Leiterplatte 1 einerseits sowie der Kameraanordnung 2 und der Beleuchtungseinrichtung 3 andererseits.

Wenngleich die Transporteinrichtung 5 grundsätzlich für die vollflächige AOI-Abrasterung der Leiterplatte 1 ausgelegt sein soll, wird hier im Folgenden - ohne Beschränkung der Allgemeinheit - ausschließlich auf die Bewegung zum Zwecke einer Spaltmessung an einem bestimmten Bauteil 11 eingegangen.

Die mit der Kameraanordnung 2 und der Beleuchtungseinrichtung 3 synchronisierte Transporteinrichtung 5 sorgt für die Bewegung der Leiterplatte 1 derart, dass ein zu prüfendes Bauteil 11 in dem Blickfeld der geneigten Kamera 21 (nur in Fig. 3 bezeichnet) so angeordnet ist, dass eine Neigungswinkelebene 22 der geneigten Kamera 21 einen rechten Winkel zu einer vertikalen Fläche B des zu prüfenden Bauteils 11 aufweist, an dem ein Spalt 13 gegenüber der Oberfläche A der Leiterplatte 1, gemessen werden soll. Dabei weist die geneigte Kamera 21 einen Neigungswinkel α gegenüber der Oberfläche A der Leiterplatte 1 auf, der zwischen 10° und 80° liegen kann, bevorzugt jedoch zwischen 40° und 70° und besonders bevorzugt zwischen 45° und 60° gewählt wird. Der letztgenannte Winkelbereich ist deshalb zu bevorzugen, da eine Bestückungsdichte der Leiterplatte 1 mit weiteren Bauteilen und Baugruppen zu berücksichtigen ist, die ansonsten bei kleineren Neigungswinkeln α zu eine Verdeckung des zu messenden Lotspaltes 13 führen könnte. Er stellt einen Kompromiss dar zwischen einer wenig verzerrten Bildaufnahme vom Spalt 13 und der Vermeidung einer Verdeckung des Lotspaltes 13 durch besonders hohe auf der Leiterplatte 1 benachbarte Bauteile oder Baugruppen (nicht dargestellt).

Der Neigungswinkel α ist in Fig. 1 dargestellt als Winkel zwischen der Oberfläche A der Leiterplatte 1 und der optischen Achse O₁ der Beleuchtungseinrichtung 3 bzw. der geneigten Kamera 21 (nur in Fig. 3 explizit gezeichnet) in einer Neigungswinkelebene 22, die orthogonal zu einer Seitenfläche B des Bauteils 11 ausgerichtet ist. Bei herkömmlicher AOI-Abtastung der Leiterplatte 1 (auch als Scannen oder Abrastern bezeichnet) ist die orthogonale Ausrichtung der Bauteile 11 bereits durch die in Scan- bzw. Abtastrichtung ausgerichtete Leiterplatte 1 eingestellt, da Bauelemente oder Bauteile 11 der Leiterplatte 1 regelmäßig in einem orthogonalen Raster zu den Kanten der Leiterplatte 1 ausgerichtet sind.

Vorzugsweise, und hier beispielhaft gezeigt, ist eine AOI-Prüfung zum Zwecke der Bestimmung von sogenanntem Standoff eines Bauteils 11, mit dem der mit Lotmaterial gefüllte Spalt 13 (nachfolgend auch Lotspalt 13) zwischen den unteren Anschlussflächen von Bauelementen oder Bauteilen 11 und einem Lötpad 12 auf der Leiterplatte 1 bezeichnet wird. Der Lotspalt 13 entsteht bei passiven Bauelementen (z.B. Widerständen, Kondensatoren) und aktiven Baulementen (z.B. Mosfet) und kann eine Spaltbreite b = 0 bis 1 mm (auch als Standoff-Höhe bezeichnet) aufweisen.

Aufgrund von ungünstigen Kontrastverhältnissen zwischen dem Gehäuse eines Bauteils 11 und der Leiterplatte 1 ist der Lotspalt 13 mit optoelektronischen Messverfahren nur sehr schwer zu detektieren. Die Erfindung nutzt deshalb die Möglichkeit der Erfassung der Spaltbreite b (auch: Spaltdicke) mittels Matrix-Kameras (mit CCD- oder CMOS-Sensor), die in einem Neigungswinkel α zur Oberfläche A der Leiterplatte 1 schräg angeordnet sind. Die geometrische Auflösung der geneigten Kamera 21 in der Objektebene (Lötpats 12 bzw. Spalt 13) sollte dabei mindestens 50 µm pro Pixel betragen. Bevorzugte Werte der optischen Auflösung liegen zwischen 15 µm/Pixel und 25 µm/Pixel. Der Neigungswinkel α der Kamera(s) 21 (es können auch zwei oder vier Kamera(s) 21 sein, um für alle Fälle der Ausrichtung von Seitenflächen B des Bauteils 11 Schrägbildaufnahmen ohne relative Drehbewegung zwischen Leiterplatte 1 und Kameraanordnung 2 vornehmen zu können) kann dabei in einem Bereich von ca. 10° bis 80° zur Leiterplatte 1 liegen. Vorteilhaft liegt der Neigungswinkel α zwischen 40° und 70°, bevorzugt ist aber der Winkelbereich von 45° bis 60°. Die letzteren Werte stellen einen akzeptablen Kompromiss dar zwischen der erzielbaren Messgenauigkeit (flachere Neigungswinkel α bewirken eine höhere Messgenauigkeit), dem benötigten Freiraum für andere Bauteile 11 (zwischen geneigter Kamera 21 und Oberfläche A der Leiterplatte 1, wofür typischerweise 30 mm bis 40 mm notwendig sind) sowie einer Verdeckung des Lotspaltes 13 durch nebenstehende, hohe Bauteile 11. In Abhängigkeit vom gewählten Neigungswinkel α der geneigten Kamera(s) 21 sind zur Berechnung des realen Spaltbreite b des Lotspaltes 13 trigonometrische Funktionen anzuwenden.

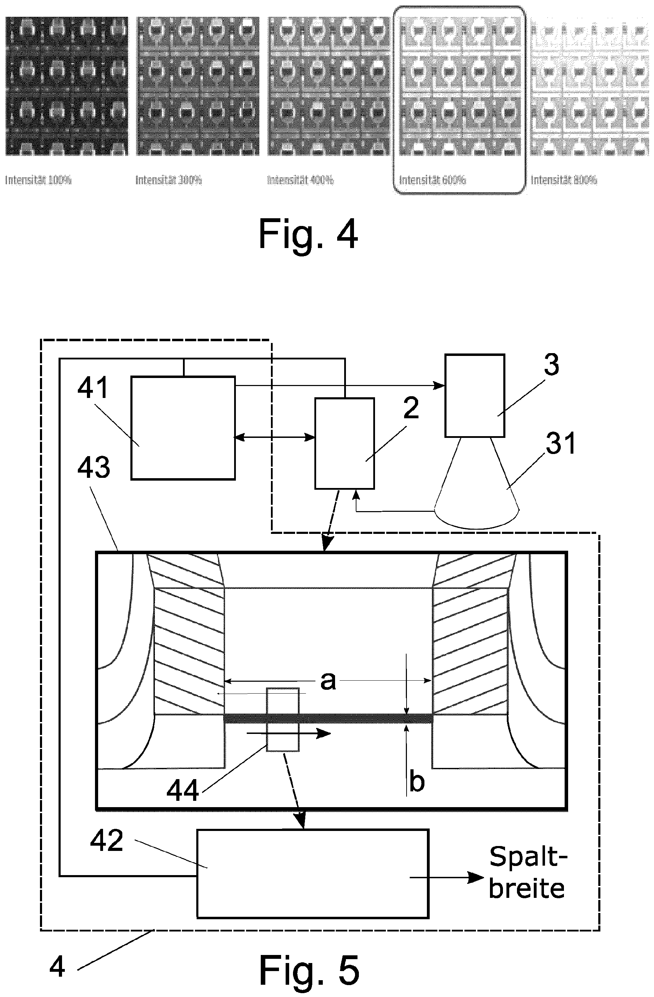

Da die Ausprägung des Lotspaltes 13 als dunkler Bereich in dem mit der geneigten Kamera 21 aufgenommenen Bild 43 (siehe Fig. 5) zusätzlich von der Beschaffenheit der unteren Gehäusekante der Seitenfläche B des Bauteils 11 abhängt (eckig, rund, schräg), sind für jede Gehäuseform Korrekturfaktoren einzuführen.

Um den Lotspalt 13 mit der geneigten Kamera 21 kontrastreich zu erkennen, ist der Einsatz von gerichteter Beleuchtung 31 senkrecht von oben auf das Bauteil 11 bzw. auf die Leiterplatte 1 erforderlich. Geringe Abweichungen um wenige Grad (bis zu 15°) sind möglich und zum Teil auch kontrastverstärkend. Der dabei entstehende dunkle Bereich zwischen Unterkante der Seitenfläche B und Oberfläche A der Leiterplatte 1 ist ein Maß für die Größe des Lotspalts 13. Die Kontrastierung des Lotspalts 13 kann durch eine Variation der Beleuchtung optimiert werden. Vorrangig wird die Beleuchtungsintensität variiert. Weiterhin kann zur Kontrastverbesserung die Wellenlänge des Lichtes, die Polarisation oder die Lage und/oder Ausformung der Beleuchtungseinrichtung variiert werden. Die Wellenlänge des Lichtes muss dabei innerhalb des Spektrums liegen, in dem die eingesetzte geneigte Kamera 21 eine ausreichende Empfindlichkeit aufweist.

Die Intensität der gerichteten Beleuchtung, Koaxialbeleuchtung 31 bzw. Ringbeleuchtung 32 (nur in Fig. 3 gezeigt) ist so zu wählen, dass ein hinreichender Kontrast zwischen der abgebildeten Seitenfläche B des Bauteils 11, dem Lotspalt 13 sowie der Oberfläche A der Leiterplatte 1 erkennbar ist. Um diesen Kontrast für die unterschiedlichsten Leiterplatten- und Bauteilbeschaffenheiten sicherstellen zu können, muss eine Möglichkeit bestehen, für die Beleuchtungsintensität (Helligkeit) einen sehr großen Variationsbereich zu wählen.

Für eine optimale Inspektion von Bauteilen 11 und Lötstellen, Lötaugen und Lötpats 12, auf der Leiterplatte 1 ist im Vorfeld der AOI-Prüfung eine Kalibrierung der Beleuchtung im Verhältnis zur Empfindlichkeit der normal (senkrecht) orientierten Kameras 23 notwendig. Dies erfolgt anhand eines Kalibriernormals und eines vorgegebenen Grauwertes in der Form, dass sowohl hell-reflektierende als auch matt-schwarze Objekte auf der Leiterplatte 1 im Grauwert-Dynamikumfang des Kamerabildes erkennbar sein müssen.

Für eine kontrastreiche Abbildung zur Messung des Lotspaltes 13 ist die sich aus der Kalibrierung ergebende Helligkeit im Allgemeinen (bei senkrechten 90°-Kameras 23, nur in Fig. 3 dargestellt) nicht ausreichend. Aus diesem Grund ist es notwendig, für den Messvorgang des Lotspaltes 13 die Helligkeit um ein Mehrfaches gegenüber dem Kalibriernormal zu erhöhen. In Abhängigkeit von der Materialfarbe der Leiterplatte 1 und der Gehäusefarbe des Bauteils 11 kann dies in einem Bereich von Faktor 2 bis Faktor 10 liegen Typische bevorzugte Werte liegen beim Drei- bis Achtfachen des Kalibriernormalwertes.

In **Fig. 2** ist eine erste Variante eines zu untersuchenden Bauteils 11, symbolisiert als klassische SMD-Bauform eines passiven Bauelements (Kondensator oder ohmscher Widerstand), mit dem zu messenden Lotspalt 13 dargestellt. Um bei ungünstigen Kontrastsituationen in Bezug auf die Leiterplatte 1 (z.B. bei sehr dunklem Lötstopplack) die Messung des Lotspaltes 13 dennoch zu ermöglichen, ist unterhalb des Bauteils 11 auf der Oberfläche A der Leiterplatte 1 ein zusätzliches Kontrastpad 14 angebracht, das den ausreichenden Kontrast zwischen Lotspalt 13 und Leiterplatte 1 verbessert. Das Kontrastpad 14 kann entweder direkt bei der Leiterplattenherstellung als zusätzliches "blindes Pad" gedruckt werden oder es wird eigens für die Prüfung durch Aufbringen einer Folie angelegt.

Eine weitere Ausführung der Erfindung ist in **Fig. 3** am Beispiel eines zweiten Bauteils 11, für das - wie schon oben erwähnt - je nach Lage und Art der Seitenfläche B und deren unteren Kantenbereich eine gesonderte Anpassung der Beleuchtung erforderlich sein kann, dargestellt.

In der Ausführungsvariante von Fig. 3 weist die Kameraanordnung 2 neben der geneigten Kamera 21 eine 90°-Kamera 23 mit einer senkrechten optische Achse O₂ - stellvertretend für eine Mehrzahl von AOI-Kameras, die die Leiterplatte 1 systematisch abrastern (scannen) - auf, wodurch die Beleuchtungseinrichtung 3 eine andere Konfiguration der Beleuchtung benötigt, um das Beleuchtungszentrum wie vorher im Blickfeld (FOV) der geneigten Kamera 2 zu behalten. Das Problem der beizubehaltenden Beleuchtungsposition gegenüber der geneigten Kamera 21 wird vorzugsweise gelöst, indem eine Ringbeleuchtung 32 um die 90°-Kamera 23 angeordnet ist, die eine vollständige Ausleuchtung des Blickfeldes der geneigten Kamera 21 gewährleistet, wobei in zentraler Position der Beleuchtungseinrichtung über dem Bauteil 11 die Ringbeleuchtung 32 einen ringförmigen Beleuchtungsstrahl an allen Seitenflächen B des Bauteils 11 für gleichzeitige Bildaufnahmen durch eine Mehrzahl von geneigten Kameras 21 ermöglicht. Damit kann die Messung eines Lotspaltes 13 in den Prozess der systematischen AOI-Kontrolle der Leiterplatte 1 problemlos integriert werden.

Das Bauteil 11 ist in Fig. 3 durch einen klassischen Leistungstransistorbaustein mit Flächenlötkontakt als Leistungsanschluss und Kühlkontakt symbolisiert, dessen Lötkontaktqualität durch Messung des Lotspaltes 13 geprüft werden soll. Erreicht der Lotspalt 13 bei der Relativbewegung der Leiterplatte 1 gegenüber der Kameraanordnung 2 und der Beleuchtungseinrichtung 3 das Blickfeld (FOV) der geneigten Kamera 21, wird die Helligkeit der Beleuchtungseinrichtung 3 beispielsweise in der abgegebenen Intensität auf das Sechsfache des Kalibriernormals der Intensität für die 90°-Kamera(s) 23 erhöht, wie es in Fig. 4 als Auswahlmöglichkeit eines 600%igen Intensitätswertes gegenüber dem Kalibriernormal angegeben ist.

Das erfindungsgemäße Verfahren zur Messung eines Lotspaltes 13 an einer Seitenfläche B eines Bauteils 11, wie es beispielhaft in Fig. 1 und Fig. 3 für unterschiedliche passive oder aktive Bauelemente dargestellt ist, umfasst bei automatischer optischer Inspektion einer zu prüfenden Leiterplatte 1, die Schritte:
- Bereitstellen einer Kameraanordnung 2, die mindestens eine geneigte Kamera 21 enthält, die unter einem Neigungswinkel α zu der Leiterplatte 1 ausgerichtet wird, um eine Seitenfläche B eines zu messenden Bauteils 11 so abzubilden, dass die Seitenfläche B auf einen vorhandenen Spalt 13 untersucht werden kann, und
- Bereitstellen einer Beleuchtungseinrichtung 3 mit einer gerichteten Beleuchtung als Koaxialbeleuchtung 31 oder als Ringbeleuchtung 32 (gemäß Fig. 3), die im Blickfeld (FOV) der geneigten Kamera 21 im Wesentlichen orthogonal zur Leiterplatte 1 ausgerichtet wird,
- Ausführen einer Relativbewegung zwischen der Leiterplatte 1 einerseits sowie der Kameraanordnung 2 und Beleuchtungseinrichtung 3 andererseits, um ein zu prüfendes Bauteil 11 in dem Blickfeld der geneigten Kamera 21 so zu positionieren, dass eine Neigungswinkelebene 22 der geneigten Kamera 21 orthogonal zu der Seitenfläche B des zu prüfenden Bauteils 11 steht,
- Ansteuern der Beleuchtungseinrichtung 3 in unterschiedlichen Beleuchtungsmodi, bei denen die Beleuchtung (Koaxialbeleuchtung 31 oder Ringbeleuchtung 32) mindestens in ihrer Helligkeit variiert wird, um eine Serie von aufgenommenen Bildern 43 vom Bauteil 11 mit dem Spalt 13 an der Seitenfläche B des Bauteils 11 mit unterschiedlichem Kontrast aufzunehmen,
- Bewerten von Kontrastverhältnissen in den mit variierter Helligkeit aufgenommenen Bildern (43) mittels einer Bildauswerteeinheit (42) und Auswählen des aufgenommenen Bildes (43) mit bestem Kontrast, um Kantenverläufe zu detektieren,
- Detektieren von Kantenverläufen in der Bildauswerteeinheit (42) und Ermitteln von gegenüberliegenden Kantenübergängen, die dem vorhandenen Spalt (13) zuzuordnen sind, und Errechnen der Spaltbreite b des Spaltes (13) als Abstand gegenüberliegender Kantenübergänge.

Zur Ermittlung der Spaltbreite b des Lotspaltes 13 innerhalb des mit der geneigten Kamera 21 aufgenommenen Bildes 43, werden gängige Bildverarbeitungs-Algorithmen eingesetzt, um die Spaltbreite b des Lotspaltes 13 aus der Abbildung des aufgenommenen Bildes 43 zu extrahieren. Dabei besteht eine wesentliche Objekterkennungsmaßnahme in der Bestimmung von Kantenübergängen, die dem Lotspalt 13 zuzuordnen sind. Hierbei können Schwellwertverfahren, Anstiegsverfahren und/oder Subpixelverfahren zum Einsatz kommen, um die Kanten des Spaltes 13 zu detektieren und um aus diesen ermittelten Bild-Koordinaten die Lotspaltbreite b zu ermitteln. Zusätzlich können für die jeweiligen aufgenommenen Bilder 43 kontrastverstärkende Verfahren (z.B. Normalisierung) eingesetzt werden, um Kontrastverbesserungen bei der Kantenermittlung oder Spaltdarstellung zu erhalten. Zur Spaltbreitenbestimmung kommt vorzugsweise im aufgenommenen Bild 43 ein Arbeitsbereich in Form einer ROI 44 (Region of Interest) zur Anwendung, um die Kantenübergänge in kleineren Abschnitten genau zu bestimmen. Die ROI 44 kann dann entlang eines im globalen aufgenommenen Bild 43 festgestellten Kantenverlaufs verschoben werden, um die Spaltbreite b abschnittsweise genau festzustellen, eine Mittelung der Einzelbereiche oder deren Darstellung als Verlauf der Spaltbreite b darzustellen.

Für die Bildaufnahmen 43 der geneigten Kamera 21 wird eine Variation der Koaxialbeleuchtung 31 oder Ringbeleuchtung 32 in der Helligkeit durch stufenweise Änderung der Intensität mittels der Beleuchtungseinrichtung 3 vorgenommen. Dabei wird die Intensität der Beleuchtung 31 oder 32 für die Bildaufnahmen 43 der geneigten Kamera 21 um das Zwei- bis Zehnfache erhöht gegenüber einem Kalibriernormal, das für die herkömmliche AOI-Abtastung der Leiterplatte 1 mittels der 90°-Kamera(s) 23 (nur in Fig. 3 dargestellt) verwendet wird. Typischerweise wird Beleuchtung mit Koaxialbeleuchtung 31 oder der Ringbeleuchtung 32 für die Bildaufnahmen 43 der geneigten Kamera 21 auf das Vier- bis Achtfache des Kalibriernormals erhöht. Der Faktor der Erhöhung wird für bestimmte Typen von Bauteilen 11 und Leiterplatten 1 meist nur einmalig bestimmt und kann im AOI-Abtastprozess für eine erforderliche Spaltmessung eines Lotspaltes 13 durch bauteilspezifische Umschaltung der Intensität der Beleuchtungseinrichtung 3 einfach realisiert werden. Insoweit verkürzt sich das erfindungsgemäße Verfahren für bekannte Bauteile 11 auf bekannten Leiterplatten 1.

**Fig. 4** zeigt in diesem Zusammenhang nochmals den Schritt der Helligkeitsvariation zur Bestimmung des Faktors der Intensitätssteigerung gegenüber einem ermittelten Kalibriernormalwert für die 90°-Kamera(s) 23 der herkömmlichen AOI-Abtastung der Leiterplatte 1.

**Fig. 5** zeigt stilisiert den Auswerteschritt zur Bestimmung der Spaltbreite b einer abgebildeten Seitenfläche B mit einem Lotspalt 13 unterhalb des Bauteils 11. Die Beleuchtungs- und Abtaststeuerung 41 sorgt dabei für die intensitätserhöhte Ansteuerung der Beleuchtungseinrichtung 3, die bei der gleichzeitig aktiv geschalteten geneigten Kamera 21 zur Ausgabe eines aufgenommenen Bildes 43 an die Bildauswerteeinheit 42 führt. In Fig. 5 ist das aufgenommene Bild 43 mittig in der stilisiert dargestellten Steuer- und Auswerteeinrichtung 4 als Screenshot der vom Bauteil 11 gemäß Fig. 2 aufgenommenen Seitenfläche B dargestellt. Die Bildauswerteeinheit 42 legt innerhalb des aufgenommen Bildes 43 sogenannte mindestens eine ROI (Region of Interest) fest, in der die Kantenübergänge des dunkel abgebildeten Lotspaltes 13 örtlich bestimmt werden und daraus unter Berücksichtigung der Bildverzerrung infolge der geneigten Kamera 21 gegenüber der Seitenfläche B des Bauteils 11 die reale Spaltbreite b errechnet wird. Die ROI 44 kann dazu auch noch entlang des Lotspaltes 13 örtlich verschoben ausgewertet werden, womit sich zwei Möglichkeiten der Angabe der Spaltbreite b ergeben, die Spaltbreite b entlang der Kantenverläufe entweder als Mittelwert oder als Verlauf der Spaltbreite b (z.B. bei keilförmigem Spalt 13 über die Spaltlänge a zu berechnen.

Die erfindungsgemäße Vorrichtung und das zugehörige Verfahren sind vor allem für Bauteile 11 der Leistungselektronik verwendbar, da in diesen Einsatzfällen die Belastung der Lötstelle besonders hoch ist und somit die Ausprägung des Lotspaltes 13 einen signifikanten Einfluss auf die Lebensdauer hat. Dies betrifft z.B. Transistoren und Dioden in verschiedenen Bauformen (DPAK, TO, SOT) sowie passive Bauelemente, wie Widerstände und Kondensatoren in unterschiedlichen Chip-Bauformen (z.B. 0603 bis 2020). Die Erfindung ist bei der hier ausführlich erläuterten Ermittlung von Lotspalten 13 nicht auf Lötverbindungen beschränkt, sondern lässt sich auch auf Sinter-, Klebe- und Schweißverbindungen anwenden, wobei sich auch vergleichbare Indikationskriterien für die Lebensdauer und Ausfallwahrscheinlichkeiten der geprüften Bauteile 11 ableiten lassen. Im Übrigen lassen sich auch Belüftungsspalte mit der erfindungsgemäßen Vorrichtung vermessen, um daraus abgeleitete Qualitätskriterien der Leiterplatte 1 zu bestimmen.

### Bezugszeichenliste

- 1: Leiterplatte
- 11: Bauteil
- 12: Lötpad
- 13: Spalt/Lotspalt
- 14: Kontrastpad

- 2: Kameraanordnung
- 21: geneigte Kamera
- 22: Neigungswinkelebene
- 23: 90°-Kamera

- 3: Beleuchtungseinrichtung
- 31: Koaxialbeleuchtung
- 32: Ringbeleuchtung (um 90°-Kamera)

- 4: Steuer- und Auswerteeinrichtung
- 41: Beleuchtungs- und Abtaststeuerung
- 42: Bildauswerteeinheit
- 43: (aufgenommenes) Bild
- 44: ROI (Region of Interest)

- O₁: erste optische Achse (der geneigten Kamera)
- O₂: zweite optische Achse (der 90°-Kamera)
- A: Oberfläche (der Leiterplatte)
- B: Seitenfläche (des Bauteils)
- a: Spaltlänge
- b: Spaltbreite
- α: Neigungswinkel

## Patentansprüche

1. Vorrichtung zur Messung eines Spaltes (13) eines Bauelements (11) auf einer mittels automatischer optischer Inspektion zu prüfenden Leiterplatte (1), umfassend:
- eine Kameraanordnung (2), **dadurch gekennzeichnet, dass die** Kameraanordnung (2) mindestens eine unter einem Neigungswinkel α zu der zu prüfenden Leiterplatte (1) angeordnete geneigte Kamera (21) enthält, die dazu ausgebildet ist, eine Seitenfläche (B) eines zu prüfenden Bauteils (11) abzubilden, um die Seitenfläche (B) auf einen vorhandenen Spalt (13) untersuchen zu können,
- eine Beleuchtungseinrichtung (3) mit einer gerichteten Beleuchtung (31;32), die in einem Blickfeld der geneigten Kamera (21) eine im Wesentlichen orthogonale Ausrichtung zur Leiterplatte (1) aufweist,
- eine Transporteinrichtung (5), die für eine relative Bewegung zwischen der Leiterplatte (1) einerseits und der Kameraanordnung (2) und der Beleuchtungseinrichtung (3) andererseits derart ausgebildet ist, dass ein zu prüfendes Bauelement (11) in dem Blickfeld der geneigten Kamera (21) so angeordnet ist, dass eine Neigungswinkelebene (22) der geneigten Kamera (21) einen rechten Winkel zu der Seitenfläche (B) des zu prüfenden Bauteils (11) aufweist, und
- eine Steuer- und Auswerteeinrichtung (4), die derart eingerichtet ist, dass die Beleuchtungseinrichtung (3) mindestens in der Helligkeit in unterschiedlichen Stufen steuerbar ist, und synchron dazu durch die mindestens eine geneigte Kamera (21) eine Serie von Bildern der Seitenfläche (B) des Bauteils (11) aufnehmbar ist, wobei
- eine Bildauswerteeinheit (42) dazu ausgebildet ist, in einem von der geneigten Kamera (21) aufgenommenen Bild (43) Kantenverläufe zu detektieren, die dem vorhandenen Spalt (13) zuzuordnen sind, von dem eine Spaltbreite b ermittelbar ist.

2. Vorrichtung nach Anspruch 1, **dadurch gekennzeichnet, dass** als Neigungswinkel α der geneigten Kamera (21) ein Winkel zwischen 10° und 80° eingestellt ist.

3. Vorrichtung nach Anspruch 1, **dadurch gekennzeichnet, dass** die geneigte Kamera (21) der Kameraanordnung (2) eine Auflösung von mindestens 50 µm/Pixel aufweist, vorzugsweise 15-25 µm/Pixel.

4. Vorrichtung nach einem der vorhergehenden Ansprüche, **dadurch gekennzeichnet, dass** die Transporteinrichtung (5) so ausgebildet ist, um die Neigungswinkelebene (22) orthogonal zu einer Seitenfläche (B) des zu prüfenden Bauteils (11) einzurichten.

5. Vorrichtung nach einem der vorhergehenden Ansprüche, **dadurch gekennzeichnet, dass** die Beleuchtungseinrichtung (3) zum Aussenden einer gerichteten Beleuchtung so ausgebildet ist, um eine gerichtete Koaxialbeleuchtung (31) synchronisiert zur Bildaufnahme der geneigten Kamera (21) zu aktivieren, wenn die Seitenfläche (B) des zu messenden Bauteils (11) im Blickfeld der geneigten Kamera (21) vorhanden ist.

6. Vorrichtung nach einem der vorhergehenden Ansprüche, **dadurch gekennzeichnet, dass** die Beleuchtungseinrichtung (3) zum Aussenden einer gerichteten Beleuchtung so ausgebildet ist, um eine um eine 90°-Kamera (24) angeordnete Ringbeleuchtung (32) synchronisiert zur Bildaufnahme der geneigten Kamera (21) zu aktivieren, wenn die Seitenfläche (B) des zu prüfenden Bauteils (11) im Blickfeld der geneigten Kamera (21) vorhanden ist, wobei die Steuer- und Auswerteeinrichtung (4) eine Beleuchtungs- und Abtaststeuerung (41) umfasst, um die Bildaufnahmen mindestens der geneigten Kamera (21), der Beleuchtungseinrichtung (3) und der Transporteinrichtung (5) zu synchronisieren.

7. Vorrichtung nach einem der vorhergehenden Ansprüche, **dadurch gekennzeichnet, dass** die Steuer- und Auswerteeinrichtung (4) eine Bildauswerteeinheit (42) umfasst, die derart ausgestattet ist, um aufgenommene Bilder (43) von einer Seitenfläche (B) des Bauteils (11) auf Kantenverläufe zu analysieren.

8. Vorrichtung nach Anspruch 7, **dadurch gekennzeichnet, dass** die Bildauswerteeinheit (42) so ausgestattet ist, um im aufgenommenen Bild (43) eine rechteckige ROI (44) orthogonal zu mindestens einem Kantenverlauf festzulegen und innerhalb der ROI (44) gegenüberliegende Kantenübergänge des Spaltes (13) zu detektieren und daraus die Spaltbreite b zu berechnen.

9. Vorrichtung nach Anspruch 8, **dadurch gekennzeichnet, dass** die Bildauswerteeinheit (42) so ausgestattet ist, um die rechteckige ROI (44) im aufgenommenen Bild (43) entlang des Kantenverlaufs zu verschieben und daraus einen Verlauf der Spaltbreite b über eine Spaltlänge a oder eine Spaltbreite b, gemittelt über eine Spaltlänge a, zu ermitteln.

10. Vorrichtung nach einem der vorhergehenden Ansprüche, **dadurch gekennzeichnet, dass** aus der ermittelten Spaltbreite b ein Indikationsfaktor für die Bestimmung der Zuverlässigkeit der Funktion des Bauteils (11) gegen Ausfallerscheinungen ableitbar ist.

11. Verfahren zur Messung eines Spaltes (13) an einer Seitenfläche (B) eines Bauteils (11) auf einer mittels automatischer optischer Inspektion zu prüfenden Leiterplatte (1), umfassend die Schritte:
- Bereitstellen einer Kameraanordnung (2), **dadurch gekennzeichnet, dass die** Kameraanordnung (2) mindestens eine geneigte Kamera (21) enthält, die unter einem Neigungswinkel α zu der Leiterplatte (1) ausgerichtet wird, eine Seitenfläche (B) eines zu messenden Bauteils (11) so abzubilden, um die Seitenfläche (B) auf einen vorhandenen Spalt (13) untersuchen zu können, und einer Beleuchtungseinrichtung (3) mit einer gerichteten Beleuchtung (31; 32), die im Blickfeld der geneigten Kamera (21) im Wesentlichen orthogonal zur Leiterplatte (1) ausgerichtet wird,
- Relativbewegung zwischen der Leiterplatte (1) einerseits sowie der Kameraanordnung (2) und Beleuchtungseinrichtung (3) andererseits, um ein zu prüfendes Bauteil (11) in dem Blickfeld der geneigten Kamera (21) so zu positionieren, dass eine Neigungswinkelebene (22) der geneigten Kamera (21) orthogonal zu der Seitenfläche (B) des zu prüfenden Bauteils (11) steht,
- Ansteuern der Beleuchtungseinrichtung (3) in unterschiedlichen Beleuchtungsmodi, bei denen die Beleuchtung (31; 32) mindestens in ihrer Helligkeit variiert wird, um eine Serie von aufgenommenen Bildern (43) des Bauteils (11) mit dem Spalt (13) an der Seitenfläche (B) des Bauteils (11) mit unterschiedlichem Kontrast aufzunehmen,
- Bewerten von Kontrastverhältnissen in den mit variierter Helligkeit aufgenommenen Bildern (43) mittels einer Bildauswerteeinheit (42) und Auswählen des aufgenommenen Bildes (43) mit bestem Kontrast, um Kantenverläufe zu erkennen,
- Detektieren von Kantenverläufen mittels der Bildauswerteeinheit (42) und Ermitteln von gegenüberliegenden Kantenübergängen, die dem vorhandenen Spalt (13) zuzuordnen sind, und Bestimmen der Spaltbreite b als Abstand gegenüberliegender Kantenübergänge.

12. Verfahren nach Anspruch 11, wobei eine Variation der Beleuchtung (31; 32) für die Bildaufnahmen (43) der geneigten Kamera (21) in der Helligkeit durch stufenweise Änderung der Intensität vorgenommen wird.

13. Verfahren nach Anspruch 12, wobei die Intensität der Beleuchtung (31; 32) für die Bildaufnahmen (43) der geneigten Kamera (21) um das Zwei- bis Zehnfache gegenüber einem Kalibriernormal für die herkömmliche AOI-Abrasterung der Leiterplatte (1) mittels 90°-Kamera (23) erhöht wird.

14. Verfahren nach einem der Ansprüche 11 bis 13, wobei die Spaltbreite b des Spaltes (13) bestimmt wird mittels Festlegen einer rechteckigen ROI (44) orthogonal zu detektierten Kantenverläufen durch
- Auswerten von Kantenübergängen innerhalb der ROI (44) auf Basis des Abstandes der Kantenübergänge oder
- Verschieben der ROI (44) entlang der Kantenübergänge und Ermitteln der Spaltbreite b entweder als Verlauf oder als Mittelwert über die Spaltlänge a.

15. Verfahren nach einem der Ansprüche 11 bis 14, wobei die ermittelte Spaltbreite b des Spaltes (13) als ein Indikationsfaktor für die Bestimmung der Zuverlässigkeit der Funktion des Bauteils (11) gegen Ausfallerscheinungen verwendet wird.

## Claims

1. A device for measuring a gap (13) of a component (11) on a printed circuit board (1) to be tested by automatic optical inspection, comprising:
- a camera arrangement (2), **characterized in that** the camera arrangement (2) includes at least one inclined camera (21) which is arranged at an inclination angle α to the printed circuit board (1) to be tested and which is configured to image a side surface (B) of a component (11) to be tested in order to be able to examine the side surface (B) for an existing gap (13),
- an illumination device (3) with a directional illumination (31; 32), which has a substantially orthogonal alignment to the printed circuit board (1) in a field of view of the inclined camera (21),
- a transport device (5) which is configured for a relative movement between the printed circuit board (1) on the one hand and the camera arrangement (2) and the illumination device (3) on the other hand in such a way that a component (11) to be tested is arranged in the field of view of the inclined camera (21) in such a way that an inclination angle plane (22) of the inclined camera (21) has a right angle to the side surface (B) of the component (11) to be tested, and
- a control and evaluation device (4) which is set up in such a way that the illumination device (3) can be controlled at least in terms of brightness in different stages, and a series of images of the side surface (B) of the component (11) can be recorded synchronously thereto by the at least one inclined camera (21), wherein
- an image evaluation unit (42) is configured to detect edge contours in an image (43) recorded by the inclined camera (21), which edge contours are attributable to the existing gap (13), of which a gap width b can be determined.

2. The device according to claim 1, **characterized in that** the angle of inclination α of the inclined camera (21) is set to an angle between 10° and 80°.

3. The device according to claim 1, **characterized in that** the inclined camera (21) of the camera arrangement (2) has a resolution of at least 50 µm/pixel, preferably 15-25 µm/pixel.

4. The device according to any one of the preceding claims, **characterized in that** the transport device (5) is configured so as to set up the inclination angle plane (22) orthogonally to a side surface (B) of the component (11) to be tested.

5. The device according to any one of the preceding claims, **characterized in that** the illumination device (3) for emitting a directional illumination is configured to activate a directional coaxial illumination (31) in a manner synchronized with the image recording of the inclined camera (21) when the side surface (B) of the component (11) to be measured is present in the field of view of the inclined camera (21).

6. The device according to any one of the preceding claims, **characterized in that** the illumination device (3) for emitting a directional illumination is configured to activate a ring illumination (32), which is arranged around a 90° camera (24), in a manner synchronized with the image recording of the inclined camera (21), when the side surface (B) of the component (11) to be tested is present in the field of view of the inclined camera (21), wherein the control and evaluation device (4) comprises an illumination and scanning control (41) in order to synchronize the image recordings of at least the inclined camera (21), the illumination device (3) and the transport device (5).

7. The device according to any one of the preceding claims, **characterized in that** the control and evaluation device (4) comprises an image evaluation unit (42) which is equipped so as to analyze recorded images (43) of a side surface (B) of the component (11) for edge contours.

8. The device according to claim 7, **characterized in that** the image evaluation unit (42) is equipped so as to define a rectangular ROI (44) orthogonal to at least one edge contour in the recorded image (43) and to detect opposite edge transitions of the gap (13) within the ROI (44) and to calculate the gap width b therefrom.

9. The device according to claim 8, **characterized in that** the image evaluation unit (42) is equipped so as to shift the rectangular ROI (44) in the recorded image (43) along the edge contour and to determine therefrom a contour of the gap width b over a gap length a or a gap width b averaged over a gap length a.

10. The device according to any one of the preceding claims, **characterized in that** an indication factor for determining the reliability of the function of the component (11) against failures can be derived from the determined gap width b.

11. A method of measuring a gap (13) on a side surface (B) of a component (11) on a printed circuit board (1) to be tested by automatic optical inspection, comprising the steps of:
- providing a camera arrangement (2), **characterized in that** the camera arrangement (2) includes at least one inclined camera (21) which is aligned at an angle of inclination α to the printed circuit board (1) in order to image a side surface (B) of a component (11) to be measured in order to be able to examine the side surface (B) for an existing gap (13), and an illumination device (3) with a directional illumination (31; 32) which is aligned substantially orthogonally to the printed circuit board (1) in the field of view of the inclined camera (21),
- providing a relative movement between the printed circuit board (1) on the one hand and the camera arrangement (2) and illumination device (3) on the other, in order to position a component (11) to be tested in the field of view of the inclined camera (21) in such a way that an inclination angle plane (22) of the inclined camera (21) is orthogonal to the side surface (B) of the component (11) to be tested,
- controlling the illumination device (3) in different illumination modes, in which the illumination (31; 32) is varied at least in terms of brightness in order to record a series of captured images (43) of the component (11) with the gap (13) on the side surface (B) of the component (11) with different contrast,
- evaluating contrast ratios in the images (43) recorded with varied brightness by means of an image evaluation unit (42) and selecting the recorded image (43) with the best contrast in order to recognize edge contours,
- detecting edge contours by means of the image evaluation unit (42) and determining opposing edge transitions which are attributable to the existing gap (13), and determining the gap width b as the distance between opposing edge transitions.

12. The method according to claim 11, wherein a variation of the illumination (31; 32) for the images (43) recorded by the tilted camera (21) is made in brightness by changing the intensity stepwise.

13. The method according to claim 12, wherein the intensity of the illumination (31; 32) for the images (43) recorded by the inclined camera (21) is increased by a factor of two to ten compared to a calibration standard for conventional AOI scanning of the printed circuit board (1) by means of a 90° camera (23).

14. The method according to any one of claims 11 to 13, wherein the gap width b of the gap (13) is determined by defining a rectangular ROI (44) orthogonal to detected edge contours by
- evaluation of edge transitions within the ROI (44) based on the distance between the edge transitions or
- moving the ROI (44) along the edge transitions and determining the gap width b either as a contour or as an average value over the gap length a.

15. The method according to any one of claims 11 to 14, wherein the determined gap width b of the gap (13) is used as an indication factor for determining the reliability of the function of the component (11) against failures.

## Revendications

1. Dispositif pour mesurer une fente (13) d'un composant (11) sur une carte de circuit imprimé (1) à tester au moyen d'une inspection optique automatique, comprenant :
- un ensemble de caméras (2), **caractérisé en ce que** l'ensemble de caméras (2), qui comprend au moins une caméra inclinée (21) disposée sous un angle d'inclinaison α par rapport à la carte de circuit imprimé (1) à tester, est configuré pour imager une face latérale (B) d'un composant (11) à tester, afin de pouvoir examiner la face latérale (B) pour détecter une fente existante (13),
- un dispositif d'éclairage (3) avec un éclairage dirigé (31 ; 32) qui présente une orientation sensiblement orthogonale à la carte de circuit imprimé (1) dans un champ de vision de la caméra inclinée (21),
- un dispositif de transport (5) qui est configuré pour un mouvement relatif entre la carte de circuit imprimé (1) d'une part et l'ensemble de caméras (2) et le dispositif d'éclairage (3) d'autre part, de telle sorte qu'un composant (11) à tester est disposé dans le champ de vision de la caméra inclinée (21) de telle sorte qu'un plan angulaire d'inclinaison (22) de la caméra inclinée (21) présente un angle droit par rapport à la face latérale (B) du composant (11) à tester, et
- un dispositif de commande et d'évaluation (4) qui est agencé de telle sorte que le dispositif d'éclairage (3) peut être commandé au moins en ce qui concerne la luminosité à différents niveaux et, en synchronisme avec cela, une série d'images de la face latérale (B) du composant (11) peut être enregistrée par ladite au moins une caméra inclinée (21), où
- une unité d'évaluation d'image (42) est conçue pour détecter, dans une image (43) prise par la caméra inclinée (21), des tracés de bords qui sont attribuables à la fente existante (13), dont une largeur de fente b peut être déterminée.

2. Dispositif selon la revendication 1, **caractérisé en ce qu'**un angle compris entre 10° et 80° est défini comme angle d'inclinaison α de la caméra inclinée (21).

3. Dispositif selon la revendication 1, **caractérisé en ce que** la caméra inclinée (21) de l'ensemble de caméras (2) présente une résolution d'au moins 50 µm/pixel, de préférence de 15 à 25 µm/pixel.

4. Dispositif selon l'une quelconque des revendications précédentes, **caractérisé en ce que** le dispositif de transport (5) est configuré pour établir le plan angulaire d'inclinaison (22) orthogonal à une face latérale (B) du composant (11) à tester.

5. Dispositif selon l'une quelconque des revendications précédentes, **caractérisé en ce que** le dispositif d'éclairage (3) destiné à émettre un éclairage directionnel est agencé pour activer un éclairage coaxial directionnel (31) de manière synchronisée avec la prise de vue de la caméra inclinée (21) lorsque la face latérale (B) du composant (11) à mesurer est présente dans le champ de vision de la caméra inclinée (21).

6. Dispositif selon l'une quelconque des revendications précédentes, **caractérisé en ce que** le dispositif d'éclairage (3) destiné à émettre un éclairage directionnel est configuré pour activer un éclairage annulaire (32) qui est disposé autour d'une caméra (24) à 90°, de manière synchronisée avec la prise de vue de la caméra (21) inclinée, lorsque la face latérale (B) du composant (11) à tester est présente dans le champ de vision de la caméra inclinée (21), le dispositif de commande et d'évaluation (4) comprenant une commande d'éclairage et de balayage (41) pour synchroniser les prises de vue d'au moins la caméra inclinée (21), du dispositif d'éclairage (3) et du dispositif de transport (5).

7. Dispositif selon l'une quelconque des revendications précédentes, **caractérisé en ce que** le dispositif de commande et d'évaluation (4) comprend une unité d'évaluation d'images (42) qui est équipée de manière à analyser des images (43) prises d'une face latérale (B) du composant (11) pour déterminer des tracés de bords.

8. Dispositif selon la revendication 7, **caractérisé en ce que** l'unité d'évaluation d'images (42) est équipée de manière à définir, dans l'image enregistrée (43), une ROI (44) rectangulaire orthogonale à au moins un tracé de bord et à détecter, à l'intérieur de la ROI (44), des transitions de bord opposées de la fente (13) et à calculer, à partir de là, la largeur de fente b.

9. Dispositif selon la revendication 8, **caractérisé en ce que** l'unité d'évaluation d'images (42) est équipée de manière à déplacer la ROI rectangulaire (44) dans l'image enregistrée (43) le long du tracé des bords et à déterminer à partir de là un tracé de la largeur de fente b sur une longueur de fente a ou une largeur de fente b, moyennée sur une longueur de fente a.

10. Dispositif selon l'une quelconque des revendications précédentes, **caractérisé en ce que** la largeur de fente b déterminée permet de déduire un facteur d'indication pour la détermination de la fiabilité du fonctionnement du composant (11) contre les phénomènes de défaillance.

11. Procédé de mesure d'une fente (13) sur une face latérale (B) d'un composant (11) sur une carte de circuit imprimé (1) à tester au moyen d'une inspection optique automatique, comprenant les étapes consistant à :
- fournir un ensemble de caméras (2), **caractérisé en ce que** l'ensemble de caméras (2) comprend au moins une caméra inclinée (21) qui est orientée selon un angle d'inclinaison α par rapport à la carte de circuit imprimé (1), une face latérale (B) d'un composant (11) à mesurer de manière à pouvoir examiner la face latérale (B) pour détecter une fente existante (13), et un dispositif d'éclairage (3) avec un éclairage directionnel (31 ; 32) qui est orienté dans le champ de vision de la caméra inclinée (21) de manière sensiblement orthogonale par rapport à la carte de circuit imprimé (1),
- réaliser un mouvement relatif entre la carte de circuit imprimé (1) d'une part et l'ensemble de caméras (2) et le dispositif d'éclairage (3) d'autre part, afin de positionner un composant (11) à tester dans le champ de vision de la caméra inclinée (21) de telle sorte qu'un plan angulaire d'inclinaison (22) de la caméra inclinée (21) soit orthogonal à la face latérale (B) du composant (11) à tester,
- commander le dispositif d'éclairage (3) dans différents modes d'éclairage, dans lesquels l'éclairage (31 ; 32) est modifié au moins dans sa luminosité, afin d'enregistrer une série d'images (43) prises du composant (11) avec la fente (13) sur la face latérale (B) du composant (11) avec un contraste différent,
- évaluer les rapports de contraste dans les images (43) prises avec une luminosité variable au moyen d'une unité d'évaluation d'image (42) et sélectionner l'image prise (43) ayant le meilleur contraste afin de détecter des tracés de bords,
- détecter des tracés de bords au moyen de l'unité d'évaluation d'images (42) et déterminer des transitions de bords opposées qui sont attribuables à la fente (13) existante, et déterminer la largeur de fente b en tant que distance de transitions de bords opposées.

12. Procédé selon la revendication 11, dans lequel une variation de l'éclairage (31 ; 32) pour les prises de vue (43) de la caméra inclinée (21) est effectuée en termes de luminosité en modifiant l'intensité par étapes.

13. Procédé selon la revendication 12, dans lequel l'intensité de l'éclairage (31 ; 32) pour les prises de vue (43) de la caméra inclinée (21) est augmentée de deux à dix fois par rapport à un étalon de calibrage pour le balayage AOI classique de la carte de circuit imprimé (1) au moyen d'une caméra à 90° (23).

14. Procédé selon l'une quelconque des revendications 11 à 13, dans lequel la largeur de fente b de la fente (13) est déterminée en définissant une ROI rectangulaire (44) orthogonale aux tracés de bords détectés par
- évaluation des transitions de bord à l'intérieur de la ROI (44) sur la base de l'espacement des transitions de bord, ou
- déplacement de la ROI (44) le long des transitions de bords et détermination de la largeur de fente b, soit sous forme de courbe, soit sous forme de valeur moyenne sur la longueur de fente a.

15. Procédé selon l'une quelconque des revendications 11 à 14, dans lequel la largeur de fente b déterminée de la fente (13) est utilisée comme facteur d'indication pour déterminer la fiabilité du fonctionnement du composant (11) vis-à-vis des phénomènes de défaillance.
